# EUROPEAN PATENT APPLICATION

(11) **EP 4 780 184 A1**
(43) Date of publication of application: **22.07.2026**
(21) Application number: 24867357.6
(22) Date of filing: 12.09.2024
(51) Int. Cl.: H10N 30/00, H10N 30/093, H10N 30/20, H10N 30/853, H10N 30/50

(54) **PIEZOELECTRIC UNIT AND PREPARATION METHOD THEREFOR, AND ELECTRONIC DEVICE**

(30) Priority: 19.09.2023 CN 202311214532
(71) Applicant: HUAWEI TECHNOLOGIES CO., LTD., Shenzhen 518129 (CN)
(72) Inventor: YOSUKE, Nakano, Shenzhen, Guangdong 518129 (CN); LU, Xiaoyu, Shenzhen, Guangdong 518129 (CN); KOJI, Nomura, Shenzhen, Guangdong 518129 (CN); ZHANG, Qiang, Shenzhen, Guangdong 518129 (CN)
(74) Representative: Gill Jennings & Every LLP
(86) International application number: PCT/CN2024/118564
(87) International publication number: WO 2025/060948

(57) **Abstract**

A piezoelectric unit, a piezoelectric unit preparation method, and an electronic device are provided, and relate to the field of piezoelectric device preparation technologies. The piezoelectric unit includes a substrate, a monocrystalline dielectric oxide layer, a first electrode layer, a perovskite-type monocrystalline seed crystal layer, and a piezoelectric layer that are stacked, where a lattice orientation ratio (100)/((100)+(001)) of the piezoelectric layer ranges from 0.7 to 0.8. The piezoelectric unit in this application has a high piezoelectric constant, so that the piezoelectric unit can be better driven. In addition, a dielectric constant of the piezoelectric layer is controlled to be within a low range, to reduce electric energy consumed during driving and heat emitted during driving.

## Description

This application claims priority to Chinese Patent Application No. 202311214532.0, filed with the China National Intellectual Property Administration on September 19, 2023 and entitled "PIEZOELECTRIC UNIT, PIEZOELECTRIC UNIT PREPARATION METHOD, AND ELECTRONIC DEVICE", which is incorporated herein by reference in its entirety.

### TECHNICAL FIELD

This application relates to the field of piezoelectric device preparation technologies, and in particular, to a piezoelectric unit, a piezoelectric unit preparation method, and an electronic device.

### BACKGROUND

In recent years, piezoelectric units made of piezoelectric materials such as lead zirconate titanate are mostly applied to micro-electromechanical system (Micro-electromechanical System, MEMS) devices such as sensors and actuators. Such a piezoelectric body is formed as a thin film on a substrate like silicon, and a piezoelectric unit formed through MEMS processing is expected to be applied to a plurality of MEMS devices, for example, a piezoelectric thin film print head, a MEMS speaker, a MEMS micromirror, and a gyroscope.

As a piezoelectric thin film material, elements such as lead, zirconium, titanium, and oxygen in the piezoelectric thin film material form a perovskite crystal structure. An ideal perovskite-type structure is a cubic lattice, but also includes a tetragonal crystal, an orthorhombic crystal, and the like that are deformed from a cubic crystal. In addition, an orientation of the crystal has a great impact on piezoelectric characteristics, especially electromechanical conversion efficiency, a dielectric constant, and a dielectric loss. A higher piezoelectric constant can more effectively perform driving. A larger capacitance indicates higher electric energy consumed during driving and more heat emitted by an element. Currently, when a high-performance piezoelectric material applied to a MEMS element like the actuator is prepared, requirements of improving a piezoelectric constant and reducing a dielectric constant cannot be met simultaneously. As a result, a prepared piezoelectric thin film material does not have a good operating state.

### SUMMARY

This application provides a piezoelectric unit, a piezoelectric unit preparation method, and an electronic device. A monocrystalline dielectric oxide layer, a first electrode layer, and a perovskite-type monocrystalline seed crystal layer whose lattice orientations are consistent with a lattice orientation of a monocrystalline substrate are sequentially grown on the monocrystalline silicon substrate, and a piezoelectric film that is based on PZT and that has a specific thickness may be formed by using a chemical solution deposition method, so that a piezoelectric unit with a high piezoelectric constant and a low dielectric constant can be prepared.

According to a first aspect, this application provides a piezoelectric unit, including a substrate, a monocrystalline dielectric oxide layer, a first electrode layer, a perovskite-type monocrystalline seed crystal layer, and a piezoelectric layer that are stacked, where a lattice orientation ratio (100)/((100)+(001)) of the piezoelectric layer ranges from 0.7 to 0.8.

In this embodiment, the monocrystalline dielectric oxide layer, the first electrode layer, and the perovskite-type monocrystalline seed crystal layer whose lattice orientations are consistent with a lattice orientation of a monocrystalline substrate are sequentially grown on the monocrystalline silicon substrate, and a piezoelectric film that is based on PZT and that has a specific thickness may be formed by using a chemical solution deposition method, so that a lattice orientation of the prepared piezoelectric unit can be consistent with the lattice orientation of the monocrystalline silicon substrate. For example, when the lattice orientation of the monocrystalline silicon substrate is (100), the orientation ratio ((100)/((100)+(001))) of (100) in the prepared piezoelectric layer may be increased, so that a piezoelectric constant of the piezoelectric layer can be improved, and the piezoelectric unit can be better driven; or when the lattice orientation of the monocrystalline silicon substrate is (001), an orientation ratio ((001)/((100)+(001))) of (001) in the prepared piezoelectric layer may be increased, to control a dielectric constant of the piezoelectric layer, and reduce electric energy consumed during driving and heat emitted during driving.

In a possible implementation, the substrate includes a monocrystalline silicon substrate or a monocrystalline SOI substrate whose lattice orientation is (100), to grow a piezoelectric unit in which the lattice orientation (100) accounts for a main proportion. This improves a piezoelectric constant of the piezoelectric unit.

In a possible implementation, a lattice orientation ratio (100)/((100)+(001)) of at least one of the monocrystalline dielectric oxide layer, the first electrode layer, and the perovskite-type monocrystalline seed crystal layer ranges from 0.7 to 0.8. In this embodiment, on the monocrystalline substrate whose lattice orientation is (100), the monocrystalline dielectric oxide layer, the first electrode layer, and the perovskite-type monocrystalline seed crystal layer in which the lattice orientation (100) accounts for a main proportion may be formed, so that the lattice orientation ratio (100)/((100)+(001)) of the piezoelectric layer grown and formed on the perovskite-type monocrystalline seed crystal layer ranges from 0.7 to 0.8. This can improve the piezoelectric constant of the piezoelectric layer, so that the piezoelectric unit can be better driven. The dielectric constant of the piezoelectric layer is controlled, and the electric energy consumed during driving and the heat emitted during driving are reduced.

In a possible implementation, the piezoelectric unit further includes a second electrode layer, the second electrode layer is located on a side that is of the piezoelectric layer and that is away from the first electrode layer, and the piezoelectric layer is located between the first electrode layer and the second electrode layer. The first electrode layer and the second electrode layer are located on two sides of the piezoelectric layer, and can generate a specific potential difference, to drive the piezoelectric layer to perform bending vibration.

In a possible implementation, the substrate has a frame structure, and is provided with a first through hole that interpenetrates each other in a thickness direction;
the piezoelectric layer is located on a side of the substrate in the thickness direction and includes at least one diaphragm, there is a second through hole between the diaphragm and the substrate and/or between two adjacent diaphragms, at least a part of an edge of the diaphragm is fastened to the substrate to form a cantilever structure, the diaphragm covers a part of the first through hole, and the second through hole and the first through hole interpenetrate each other; and
the piezoelectric unit further includes an organic film, and the organic film covers the diaphragm and the second through hole.

In this embodiment, a diaphragm actuating structure is disposed, so that a speaker unit has a cantilever structure. Because one end of the cantilever structure is disposed in a suspended manner, actuating performance of the speaker unit is improved, and output power of the speaker unit can be improved.

According to a second aspect, this application provides an electronic device, including a housing and the piezoelectric unit according to any one of the foregoing implementations, the housing encloses an inner cavity, and the piezoelectric unit is located in the inner cavity and is fastened in the housing. In the electronic device in this application, the piezoelectric unit in the electronic device has a high piezoelectric constant and a small dielectric constant, and the piezoelectric unit has a high driving capability and generates a small amount of heat during driving.

In a possible implementation, the electronic device further includes a controller, the controller is electrically connected to the piezoelectric unit, and the controller is configured to control vibration of the piezoelectric unit.

According to a third aspect, this application provides a piezoelectric unit preparation method, including the following steps:
sequentially forming a monocrystalline dielectric oxide layer, a first electrode layer, and a perovskite-type monocrystalline seed crystal layer on a monocrystalline substrate, where the monocrystalline dielectric oxide layer is a monocrystalline oxide layer epitaxially grown on the monocrystalline substrate;
coating a precursor solution on the perovskite-type monocrystalline seed crystal layer to form an intermediate, where the intermediate includes the monocrystalline substrate, the monocrystalline dielectric oxide layer, the first electrode layer, the perovskite-type monocrystalline seed crystal layer, and the precursor solution; and
drying, calcining, and cooling the intermediate, so that the precursor solution crystallizes and solidifies into a piezoelectric layer.

In a possible implementation, the monocrystalline substrate includes a monocrystalline silicon substrate or a monocrystalline SOI substrate. A thickness of the monocrystalline substrate may range from 300 micrometers to 800 micrometers. A lattice orientation of the monocrystalline substrate may be a silicon substrate with a crystal plane index (100) or a silicon substrate with a crystal plane index (001), and is used for preparation of a piezoelectric unit in this application, to facilitate formation of a lattice orientation required for growing the piezoelectric layer.

In a possible implementation, lattice orientations of the monocrystalline silicon substrate and the monocrystalline SOI substrate are (100), so that a piezoelectric unit in which the lattice orientation (100) accounts for a main proportion is grown, and a piezoelectric constant of the piezoelectric unit is improved.

In a possible implementation, the first electrode layer includes at least one of a platinum electrode layer, a silver electrode layer, a copper electrode layer, and a gold electrode layer, to form an electrode layer on a side of the piezoelectric layer in the piezoelectric unit.

In a possible implementation, the perovskite-type monocrystalline seed crystal layer is made of at least one material of strontium ruthenate, lead lanthanum titanate, and lanthanum sodium oxide tetrahydrate, to form a piezoelectric unit of a perovskite-type structure.

In a possible implementation, after steps of drying, calcining, and cooling the intermediate, steps of coating, drying, calcining, and cooling the precursor solution are repeatedly performed on the formed piezoelectric layer until a piezoelectric layer of a preset thickness is formed. Steps of coating, drying, calcining, and cooling are performed for a plurality of times, so that a piezoelectric layer with high density and a specific thickness can be formed.

In a possible implementation, a step of coating the precursor solution on the perovskite-type monocrystalline seed crystal layer includes:
the precursor solution contains zirconium and titanium, and a ratio of zirconium to titanium in the precursor solution is adjusted to determine that an orientation ratio (100)/((100)+(001)) of the piezoelectric layer formed through drying, calcination, and cooling ranges from 0.7 to 0.8. The prepared piezoelectric unit has a high piezoelectric constant and a small dielectric constant.

In a possible implementation, a ratio of a molar quantity of zirconium to a molar quantity of titanium in the precursor solution ranges from 0.5 to 1, so that the orientation ratio (100)/((100)+(001)) of the prepared piezoelectric unit ranges from 0.7 to 0.8, and the prepared piezoelectric unit has the high piezoelectric constant and the small dielectric constant.

In a possible implementation, a step of calcining the precursor solution includes: heating the precursor solution to a first preset temperature, until the precursor solution is sintered and solidified; and continuing to heat the precursor solution to a second preset temperature, so that the precursor solution crystallizes. Pre-sintering is first performed at the first preset temperature, so that the precursor solution is sintered and solidified. Then, calcination is performed at the second preset temperature, so that the solidified precursor solution crystallizes. In this way, a piezoelectric layer in a monocrystalline phase is formed.

### BRIEF DESCRIPTION OF DRAWINGS

FIG. 1 is a schematic flowchart of a piezoelectric unit preparation method according to an implementation of this application;
FIG. 2 is a diagram of XRD representation of a piezoelectric unit according to this application;
FIG. 3 is a diagram of a correspondence between a voltage and strain according to an implementation of this application;
FIG. 4 is a diagram of strain of a lattice orientation (001) according to an implementation of this application;
FIG. 5 is a diagram of strain of a lattice orientation (100) according to an implementation of this application;
FIG. 6 is a diagram of a correspondence between a piezoelectric constant d31 and content of zirconium according to an implementation of this application;
FIG. 7 is a diagram of a correspondence between a dielectric constant and content of zirconium according to an implementation of this application;
FIG. 8 is a diagram of structures of layers of a piezoelectric unit according to an implementation of this application;
FIG. 9 is a three-dimensional diagram of a speaker unit according to an implementation of this application;
FIG. 10 is an exploded view of a structure of the speaker unit in FIG. 9 according to this application;
FIG. 11 is a partial sectional view of a structure of the speaker unit in FIG. 9 according to this application;
FIG. 12 is a three-dimensional diagram of a diaphragm and a base layer of the speaker unit in FIG. 9 according to this application;
FIG. 13 is a diagram of a structure of a true wireless earphone according to an implementation of this application; and
FIG. 14 is a sectional view of the true wireless earphone in FIG. 13 according to this application.

### DESCRIPTION OF EMBODIMENTS

The following describes embodiments of this application with reference to accompanying drawings in embodiments of this application.

For ease of understanding, the following first describes English abbreviations and related technical terms in embodiments of this application.

It should be noted that the described embodiments are merely some rather than all of embodiments of this application. All other embodiments obtained by a person of ordinary skill in the art based on embodiments of this application without creative efforts shall fall within the protection scope of this application.

The terms used in embodiments of this application are merely for the purpose of illustrating specific embodiments, and are not intended to limit this application. The terms "a", "said" and "the" of singular forms used in embodiments and the appended claims of this application are also intended to include plural forms, unless otherwise specified in the context clearly.

It should be understood that the term "and/or" in this specification is merely a same field for describing associated objects and represents that three relationships may exist. For example, A and/or B may represent the following three cases: Only A exists, both A and B exist, and only B exists. In addition, the character "/" in this specification usually indicates an "or" relationship between associated objects.

Depending on the context, for example, the word "if" used herein may be explained as "while", "when", "in response to determining", or "in response to detecting". Similarly, depending on the context, the phrase "if determining" or "if detecting (a stated condition or event)" may be explained as "when determining", "in response to determining", "when detecting (the stated condition or event)", or "in response to detecting (the stated condition or event)".

It should be understood that, "first", "second", and the like used in this application are merely used for distinguishing and description, but cannot be understood as an indication or implication of relative importance or an indication or implication of a sequence.

In descriptions of this application, orientations or position relationships indicated by the terms "center", "upper", "lower", "front", "rear", "left", "right", "vertical", "horizontal", "top", "bottom", "inner", "outer", and the like are based on orientations or position relationships shown in the accompanying drawings, and are merely intended for ease of describing this application and simplifying descriptions, instead of indicating or implying that a specified apparatus or component needs to have a specific orientation, and be constructed and operated in the specific orientation. Therefore, this cannot be understood as a limitation on this application.

In this application, "in a range of..." includes end values at both ends of the range by default except that it is separately indicated that an end value is not included. For example, a range of 1 to 5 includes the two values 1 and 5.

A lattice orientation, also referred to as a crystal orientation, generally refers to directionality of a crystal, that is, a tendency direction of forming covalent bonds in a specific direction. According to the quantum theory of covalent bonds, strength of the covalent bonds depends on a degree of overlapping of electron clouds. Due to asymmetric distribution of non-filled shell electrons, lattice growth tends to grow in a direction of maximum electron cloud density to form bonds.

In the descriptions of this application, it should be noted that, unless otherwise expressly specified and limited, terms such as "mount", "interconnect", and "connect" should be understood in a broad sense, for example, may be a fixed connection, a detachable connection, an abutting connection, or an integral connection. A person of ordinary skill in the art may understand specific meanings of the foregoing terms in this application based on specific situations.

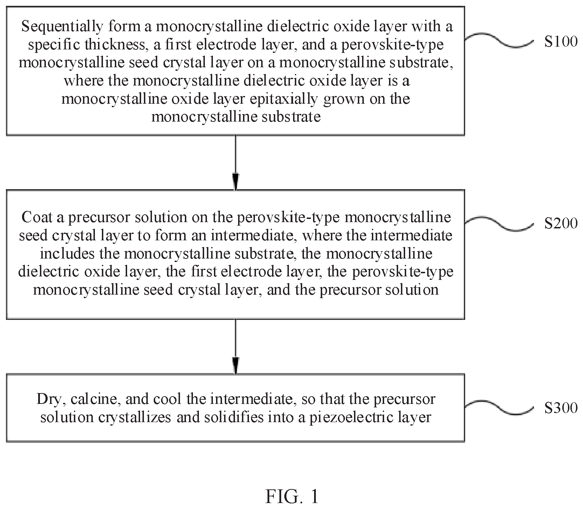

This application provides a piezoelectric unit preparation method. Refer to FIG. 1. The method includes the following steps.

Step S100: Sequentially form a monocrystalline dielectric oxide layer with a specific thickness, a first electrode layer, and a perovskite-type monocrystalline seed crystal layer on a monocrystalline substrate, where the monocrystalline dielectric oxide layer is a monocrystalline oxide layer epitaxially grown on the monocrystalline substrate.

The monocrystalline substrate is first prepared. The monocrystalline substrate may be a monocrystalline silicon substrate, or may be a silicon-on-insulator (Silicon-On-Insulator, SOI) substrate. The SOI substrate introduces a buried oxide layer between top-layer silicon and a backing substrate, and can implement dielectric isolation of components in an integrated circuit, and completely eliminate a parasitic latch-up effect in a bulk CMOS circuit. In this application, the monocrystalline silicon substrate is used as an example.

A thickness of the monocrystalline silicon substrate may range from 300 micrometers to 800 micrometers, and the monocrystalline silicon substrate may be a circular substrate. A radius of the circular substrate is related to a size of a formed piezoelectric unit. This may not be specifically limited in this application. In addition, a lattice orientation of the monocrystalline silicon substrate may be a silicon substrate with a crystal plane index (100) or a silicon substrate with a crystal plane index (001), and is used for preparation of the piezoelectric unit in this application, to facilitate formation of a lattice orientation required for growing a piezoelectric layer. It should be noted that, when the SOI substrate is used, the SOI substrate may alternatively be a monocrystalline substrate whose lattice orientation is (100) or (001).

In this application, the monocrystalline substrate constitutes a substrate prepared in the piezoelectric unit, and lattice orientations of the monocrystalline dielectric oxide layer, the first electrode layer, the perovskite-type monocrystalline seed crystal layer, and the piezoelectric layer that are formed on the monocrystalline substrate are all related to the monocrystalline substrate.

The monocrystalline dielectric oxide layer with the specific thickness is formed on the monocrystalline silicon substrate. The monocrystalline dielectric oxide layer may be made of at least one of materials such as zirconium oxide (ZrO₂), yttria-stabilized zirconia (YSZ), and hafnium oxide (HfO₂). A preparation thickness may range from 20 nanometers to 100 nanometers, to prepare a buffer layer located on the substrate. A monocrystalline dielectric oxide layer made of a material like ZrO₂ is used to constitute the buffer layer on the substrate (monocrystalline substrate). Specifically, the buffer layer may be formed on the substrate by using a metal organic chemical vapor deposition (metal organic chemical vapor deposition, MOCVD) process, an electron beam evaporation process, a sputtering process, or another applicable process.

In an embodiment, the monocrystalline substrate is used as a vibration layer, and the monocrystalline dielectric oxide layer formed on the monocrystalline silicon substrate may be used as the buffer layer. A thickness of the buffer layer may be about 60 nanometers, for example, may range from 55 nanometers to 65 nanometers.

In an embodiment, the formed buffer layer may be further used as a vibration plate of the piezoelectric unit, and stiffness of the vibration plate has an important impact on a natural frequency and a resonant frequency of the vibration plate. Higher stiffness can make the natural frequency of the vibration plate higher, thereby improving frequency stability of the vibration plate. In addition, when the piezoelectric unit is used in an actuator, sensitivity of the vibration plate is an important indicator. Higher stiffness can make the piezoelectric unit more sensitive to external excitation, and make it easier to generate displacement or a response, thereby improving performance of the actuator. In addition, in this embodiment, the thickness of the buffer layer may be controlled within a range of 200 nanometers to 8000 nanometers, so that the buffer layer 120 has specific stiffness. In addition, the buffer layer needs to have a large thickness. An increase in the thickness also means that a lateral size needs to be increased, and a lateral constraint on the buffer layer is also increased. The lateral constraint may enable the buffer layer to generate greater resistance when being stressed. Therefore, stiffness of the buffer layer is increased with the increase in the thickness.

In addition, the monocrystalline silicon substrate is used in this application, for example, a monocrystalline silicon substrate whose lattice orientation is (100). The monocrystalline oxide layer may be epitaxially grown on the monocrystalline silicon substrate. In this case, the lattice orientation of the dielectric oxide layer may be consistent with the lattice orientation of the monocrystalline silicon substrate to form the dielectric oxide layer whose lattice orientation is

(100). The dielectric oxide layer may be used as a seed layer of the electrode layer, the perovskite-type monocrystalline seed crystal layer and the piezoelectric layer that are grown subsequently, so that the grown seed layer may be of a monocrystalline structure.

After the monocrystalline dielectric oxide layer is formed, the first electrode layer is formed on the monocrystalline dielectric oxide layer. The first electrode layer may be made of at least one metal material such as platinum (Pt), silver (Ag), copper (Cu), and gold (Au). In this application, that the first electrode layer is a Pt electrode is used as an example, and an electrode film may be formed on a first buffer layer by using a sputtering method.

In this application, because a lattice orientation of silicon is (100), and ZrO₂ grows on the monocrystalline silicon (grows along a same orientation as silicon), a lattice orientation of ZrO₂ is also (100). In addition, an electrode layer grown on ZrO₂ also grows along the same orientation, and a Pt electrode layer also grows along the lattice orientation (100).

After the Pt electrode layer is formed, the perovskite-type monocrystalline seed crystal layer is formed on the Pt electrode layer. Specifically, a monocrystalline seed layer with a perovskite-type structure may be formed on the Pt electrode layer by using at least one material such as strontium ruthenate (SRO), lead lanthanum titanate (PLT), and lanthanum sodium oxide tetrahydrate (LNO) by using a method like the sputtering method. Specifically, the perovskite-type monocrystalline seed crystal layer forms a film layer structure on the Pt electrode layer. Because the Pt electrode layer is mostly in the lattice orientation (100), the perovskite-type monocrystalline seed crystal layer grown on the Pt electrode layer may also grow along the lattice orientation (100).

Step S200: Coat a precursor solution on the perovskite-type monocrystalline seed crystal layer to form an intermediate, where the intermediate includes the monocrystalline substrate, the monocrystalline dielectric oxide layer, the first electrode layer, the perovskite-type monocrystalline seed crystal layer, and the precursor solution.

The precursor solution is an oxide that includes elements such as lead, zirconium, and titanium, and is used to form a piezoelectric layer material. For example, in this embodiment, the precursor solution is Pb(ZrₓTi₍₁₋ₓ₎)O₃. The precursor solution may be coated on a wafer (a wafer structure including the monocrystalline silicon substrate, the first electrode layer, and the perovskite-type monocrystalline seed crystal layer) by using a spin coater, and the precursor solution may be in a sol state. In addition, an amount of the precursor solution finally spin-coated on the wafer is adjusted by controlling parameters such as a rotation speed, spin coating duration, and a spin coating solution amount of the spin coater, to achieve a preset designed thickness of the piezoelectric layer. Herein, x is a proportion of zirconium to a total content of zirconium and titanium, and 1-x is a proportion of titanium to the total content of zirconium and titanium. The proportion may affect a proportion of a lattice orientation in the prepared piezoelectric layer.

Step S300: Dry, calcine, and cool the intermediate, so that the precursor solution crystallizes and solidifies into the piezoelectric layer.

After the precursor solution is coated, the precursor solution may be heated and dried by using a device like a heating plate or an electric furnace. A heating temperature may range from 100°C to 150°C, and heating is performed within a range of 10 minutes to 30 minutes within a temperature range of 100°C to 150°C. Through heating in this step, a substance like an organic solvent in the precursor solution can be removed, to facilitate formation of a denser piezoelectric layer.

After the precursor solution is heated for 10 minutes to 30 minutes within the range of 100°C to 150°C, the precursor solution may be continuously heated to a range of 600°C to 700°C using a device like a rapid thermal annealing (RTA) furnace for calcination, and heated for 5 minutes to 30 minutes within the range of 600°C to 700°C. In a calcination process, a gas like oxygen is introduced, and a dense seed layer is formed through cooling.

In an embodiment, after the precursor solution is dried, the precursor solution may be first heated to a range of 200°C to 450°C, and heating duration of the precursor solution is maintained within a range of 10 minutes to 30 minutes at a temperature within the range of 200°C to 450°C, to pre-sinter the precursor solution, so that the precursor solution is sintered and solidified. The solidified precursor solution is then heated to the range of 600°C to 700°C for calcination, so that the solidified precursor solution crystallizes and forms a piezoelectric layer with a monocrystalline orientation.

In this application, a PZT thin film whose lattice orientation is preferably (100) may be prepared on the Pt electrode layer by using a chemical solution deposition (Chemical solution deposition, CSD) method, so that the prepared piezoelectric layer may include a crystal structure with a specific content of the lattice orientation (100).

In this embodiment, the monocrystalline dielectric oxide layer, the first electrode layer, and the perovskite-type monocrystalline seed crystal layer whose lattice orientations are consistent with the lattice orientation of the monocrystalline substrate are sequentially grown on the monocrystalline silicon substrate, and a piezoelectric film that is based on PZT and that has a specific thickness may be formed by using the chemical solution deposition method, so that a lattice orientation of the prepared piezoelectric unit can be consistent with the lattice orientation of the monocrystalline silicon substrate. For example, when the lattice orientation of the monocrystalline silicon substrate is (100), the orientation ratio ((100)/((100)+(001))) of (100) in the prepared piezoelectric layer may be increased, so that a piezoelectric constant of the piezoelectric layer can be improved, and the piezoelectric unit can be better driven; or when the lattice orientation of the monocrystalline silicon substrate is (001), an orientation ratio ((001)/((100)+(001))) of (001) in the prepared piezoelectric layer may be increased, to reduce a dielectric constant of the piezoelectric layer, and reduce electric energy consumed during driving and heat emitted during driving.

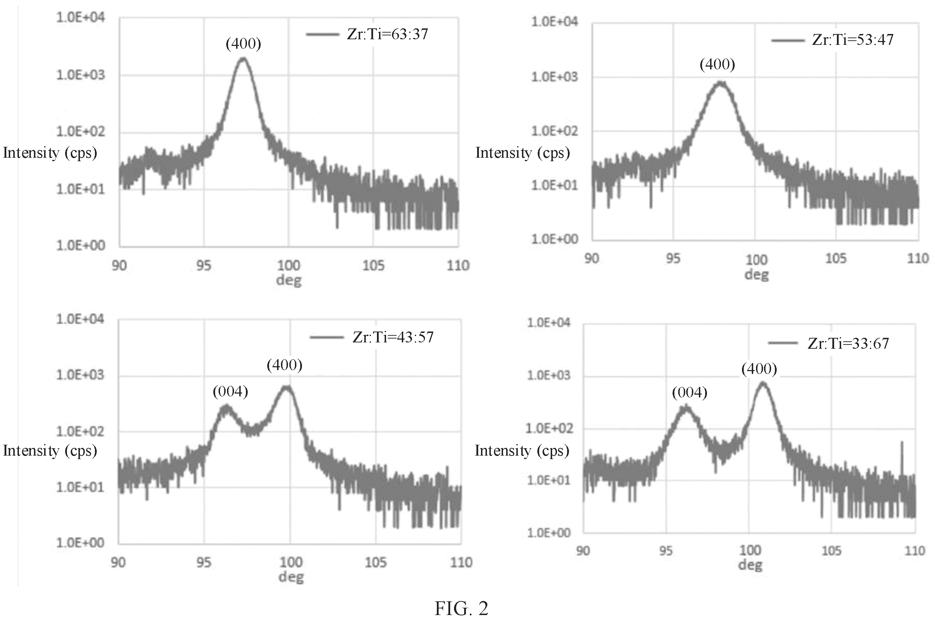

In this embodiment, with the piezoelectric unit prepared by using the monocrystalline silicon substrate whose lattice orientation is (100), reflection intensity of the prepared piezoelectric unit is represented through 20-Xφ scanning of X-ray diffraction. Refer to FIG. 2. In the following XRD pattern, XRD peaks (400) and (004) are separately shown, (100) and (400) are equivalent, and (001) and (004) are equivalent. For example, Zr:Ti ratios are 43:57 and 53:47. When Zr:Ti ratios are 63:37 and 53:47, there is only the peak (400), and a proportion of a lattice with the orientation (100) is close to 100%. For example, a Zr:Ti ratio is 43:57. In this case, reflection intensity of a lattice orientation (100) accounts for approximately 80% of a sum of mixed intensities of lattice orientations (001) and (100). For example, a Zr:Ti ratio is 33:67. In this case, reflection intensity of a lattice orientation (100) accounts for approximately 75% of a sum of mixed intensities of lattice orientations (001) and (100). 43:57 and 33:67 are calculated based on intensity ratios of the two peaks. For example, when the ratio is 33:67, intensity of the peak (400) is 724, and intensity of the peak (004) is 242. In this case, 724/(724+242)=75%. When the Zr:Ti ratio is 63:37, the proportion of the lattice with the orientation (100) is about 75%. The Zr:Ti ratio is a molar ratio. Proportions of the lattice orientations (100) and (001) in the prepared piezoelectric unit can be adjusted by adjusting the Zr:Ti ratio in the precursor solution, to prepare a piezoelectric unit with a high piezoelectric constant and dielectric constant.

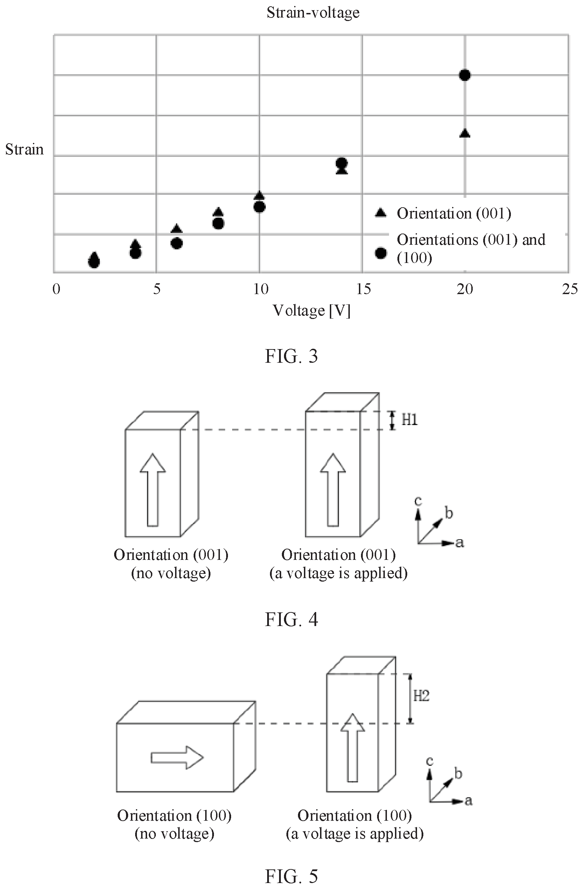

In this embodiment, after the piezoelectric layer is formed, a structure like a second electrode layer is further formed on the piezoelectric layer, so that the electrode layers are formed on both upper and lower sides of the piezoelectric layer, and the piezoelectric layer is located between the first electrode layer and the second electrode layer. Refer to FIG. 3. The electrode layers are respectively formed on the upper and lower sides of the piezoelectric layer deposited on the piezoelectric unit, to form a simple vibration structure element. A deformation amount of a lattice orientation film in which (100) and (001) coexist in this application is compared with a deformation amount of a piezoelectric thin film whose lattice orientation is completely (001) by studying the deformation amount. When a low voltage (within a range of 0 V to 10 V) is applied, strain corresponding to the piezoelectric thin film whose lattice orientation is completely (001) is greater than strain corresponding to the lattice orientation film in which (100) and (001) coexist in this application. As the applied voltage increases, when the applied voltage reaches more than 10 V, in this application, the strain corresponding to the lattice orientation film in which (100) and (001) coexist gradually becomes greater than the strain corresponding to the piezoelectric thin film whose lattice orientation is completely (001), to meet a requirement of more high-power devices for vibration intensity of the piezoelectric unit.

Refer to FIG. 4. When the lattice orientation is (001), a domain is parallel to an axis c (a vertically upward direction in FIG. 4, which is consistent with a direction of a voltage applied to the two electrode layers of the piezoelectric unit). Correspondingly, for an applied voltage extended in a direction of the axis c, it can be observed that a lattice deforms in a linear extension direction of the voltage.

Refer to FIG. 5. When the lattice orientation is (100), the domain faces an axis a (a horizontal rightward direction in FIG. 4). When a voltage along the axis c is applied, the domain rotates 90° in a direction from the axis a to an electric field (which is the axis c in this case) and is deformed. The strain is greater than a common piezoelectric strain. For example, a deformation amount H2 in FIG. 5 is greater than a deformation amount H1 in FIG. 4.

In addition, domain rotation requires a large electric field. Refer to FIG. 3. There is a threshold voltage for causing domain rotation in a voltage within a voltage range of 10 V to 14 V, so that after the applied voltage exceeds the threshold voltage, a deformation amount of a lattice with (100) in the axis c direction under the action of the voltage in the axis c direction is greater than a deformation amount of a lattice with (001) in the axis c direction.

In addition, in the piezoelectric unit prepared in this application, a lattice orientation of the piezoelectric film is mainly (100), and may account for 70% to 80% of a sum of the lattice orientations (100) and (001). Most lattice orientations in the piezoelectric film are consistent in a direction. When a high voltage (a voltage greater than 10 V) is applied, a degree of cancellation of piezoelectric strain between adjacent crystals is reduced, and the lattice with the lattice orientation (100) has a larger deformation amount than the lattice with the lattice orientation (001), so that the prepared piezoelectric unit has a high piezoelectric characteristic.

In this embodiment, the dielectric constant may be measured by using an impedance measurement instrument, for example, by using a parallel plate method. The parallel plate method is also referred to as a three-terminal method in the ASTM D150 standard. A principle of the parallel plate method is as follows: A material or thin liquid film is inserted between two electrodes to form a capacitor, then capacitance of the capacitor is measured, and the dielectric constant is calculated based on a measurement result. In an actual test apparatus, two electrodes are mounted on a test fixture that clamps a dielectric material. In this embodiment, the dielectric constant of the prepared piezoelectric layer with the monocrystalline orientation can be measured. When an orientation proportion of the lattice orientation (001) in the piezoelectric layer is close to 100%, the dielectric constant is about 500 K. When an orientation proportion of the lattice orientation (100) in the piezoelectric layer is close to 100%, the dielectric constant is about 1000 K. When the piezoelectric layer is in an amorphous state, the dielectric constant is about 1800 K. It can be learned that the formed piezoelectric layer of a monocrystalline can effectively reduce the dielectric constant of the piezoelectric unit. Especially when the proportion of the crystal orientation (001) in the piezoelectric layer is high, the dielectric constant is small. In this embodiment, the piezoelectric layer produced by using the monocrystalline (100) silicon substrate in the foregoing implementation may be used, so that the orientation ratio (100)/((100)+(001)) of the formed piezoelectric layer may be finally controlled to be within a range of 0.7 to 0.8, and the dielectric constant of the piezoelectric unit is measured to be about 900 K. Compared with that of a piezoelectric layer of an amorphous structure, the dielectric constant has been significantly reduced. In addition, the lattice orientation (100) has a high orientation proportion, and the lattice corresponding to the lattice orientation (100) has the larger deformation amount, so that the prepared piezoelectric unit has a higher piezoelectric characteristic.

In an implementation, in step S200 and step S300, coating, drying, calcination, and cooling processes may be used for a plurality of times, to form a piezoelectric layer with a preset thickness. A thickness of a finally formed piezoelectric layer may be within 5 micrometers.

After the precursor solution is spin-coated on the seed layer, and a piezoelectric layer with a specific thickness is formed through drying, calcination, and cooling, the precursor solution is spin-coated on the formed piezoelectric layer again, and the piezoelectric layer with the specific thickness is formed through corresponding drying, calcination, and cooling processes. After the plurality of (at least two) times of coating, drying, calcination, and cooling processes, a piezoelectric layer with a final preset thickness is formed. For example, the preset thickness is 2 micrometers.

In a possible implementation, in step S300, a step of calcining the precursor solution includes: gradually heating the precursor solution to a plurality of calcination temperature values, and maintaining the precursor solution at each calcination temperature value for specific duration.

In this embodiment, the precursor solution may be first heated to a first preset temperature, and maintained at the first preset temperature for specific duration, so that the precursor solution is sintered and solidified. After the precursor solution is solidified, the precursor solution is heated to a second preset temperature, where the second preset temperature is greater than the first preset temperature, and the precursor solution is maintained at the second preset temperature for specific duration, so that the solidified precursor solution crystallizes and forms a piezoelectric layer of a monocrystalline orientation.

For example, after the precursor solution is dried, the precursor solution may be first heated to the range of 200°C to 450°C, and the heating duration of the precursor solution is maintained within the range of 10 minutes to 30 minutes at the temperature within the range of 200°C to 450°C, to pre-sinter the precursor solution, so that the precursor solution is sintered and solidified. The solidified precursor solution is then heated to the range of 600°C to 700°C for calcination, so that the solidified precursor solution crystallizes and forms the piezoelectric layer with the monocrystalline orientation.

In an implementation, in step S200, a ratio of zirconium to titanium in the precursor solution may be further adjusted, to determine that the orientation ratio (100)/((100)+(001)) in the piezoelectric layer formed through drying, calcining, and cooling in step S300 ranges from 0.7 to 0.8.

In this implementation, an example in which the precursor solution is Pb(ZrₓTi₍₁₋ₓ₎)O₃ may be used, where x is a percentage of zirconium in the precursor solution to the total amount of zirconium and titanium.

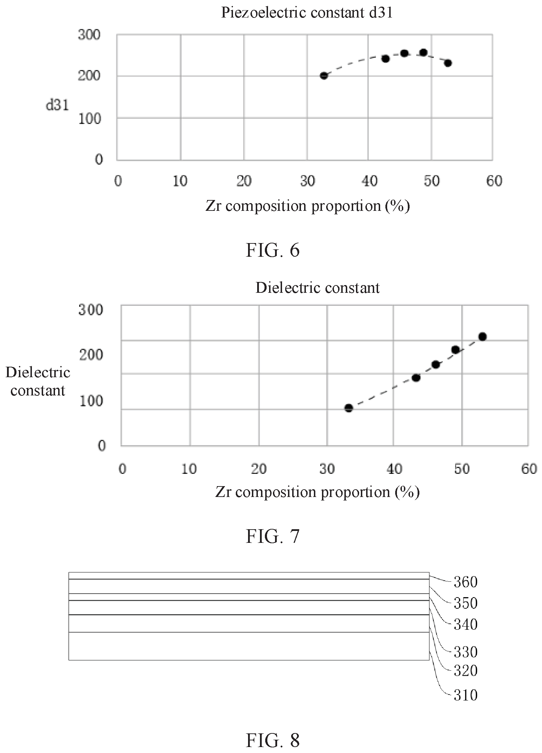

FIG. 6 is a diagram of a ratio of a piezoelectric constant of the piezoelectric unit to content of zirconium in the precursor solution. FIG. 7 is a diagram of a ratio of a dielectric constant of the piezoelectric unit to content of zirconium in the precursor solution.

Refer to FIG. 6 and FIG. 7. A higher composition proportion of zirconium in the precursor solution indicates a higher piezoelectric constant of the prepared piezoelectric layer and a larger dielectric constant. Therefore, a composition proportion of zirconium in the precursor solution may be increased to form a piezoelectric layer with a higher piezoelectric constant, and the composition proportion of zirconium in the precursor solution may be decreased to form a piezoelectric layer with a lower dielectric constant. In addition, according to selection of a usage scenario of the piezoelectric unit, and with reference to a relationship between the piezoelectric constant and the composition proportion of zirconium and a relationship between the dielectric constant and the composition proportion of zirconium in the precursor solution that are shown in FIG. 6 and FIG. 7, a range of driving that is oriented towards a high-performance actuator and that considers both a low dielectric constant and a high piezoelectric constant can be selected.

In an embodiment, the ratio of the content of zirconium to the total content of zirconium and titanium in the precursor solution may be limited to a range of 0.35 to 0.5, and a ratio of a molar quantity of zirconium to a molar quantity of titanium in the precursor solution is limited to a range of 0.5 to 1. In this case, the piezoelectric constant of the prepared piezoelectric layer ranges from 200 N/C to 250 N/C, and the dielectric constant ranges from 700 K to 1400 K. For example, the precursor solution is Pb(ZrₓTi₍₁₋ₓ₎)O₃. A value of x may range from 0.35 to 0.5. While a large piezoelectric constant is maintained, a dielectric constant characteristic value of a dielectric constant below 1500 is obtained.

This application further provides a piezoelectric unit that may be prepared by using the piezoelectric unit preparation method in any one of the foregoing implementations. Refer to FIG. 8. The piezoelectric unit includes a substrate and a piezoelectric layer that are stacked, and a lattice orientation ratio (100)/((100)+(001)) of the piezoelectric layer ranges from 0.7 to 0.8.

The piezoelectric unit includes a substrate 310, a monocrystalline dielectric oxide layer 320, a first electrode layer 330, a perovskite-type monocrystalline seed crystal layer 340, and a piezoelectric layer 350 that are sequentially stacked. A structure of each layer may be prepared by using the preparation method in the foregoing implementations. Details are not described herein again.

The substrate 310, the monocrystalline dielectric oxide layer 320, the first electrode layer 330, the perovskite-type monocrystalline seed crystal layer 340, and the piezoelectric layer 350 that are stacked may all be of a layered structure, and the structures of the layers have a same shape and a same size on an extended plane, so that the piezoelectric unit forms a multi-layer composite structure.

The lattice orientation ratio (100)/((100)+(001)) of the piezoelectric layer ranges from 0.7 to 0.8, and a lattice orientation ratio (100)/((100)+(001)) of at least one of the monocrystalline dielectric oxide layer, the first electrode layer, and the perovskite-type monocrystalline seed crystal layer may also range from 0.7 to 0.8.

In an implementation, the piezoelectric layer 350 is further provided with a second electrode layer 360. The second electrode layer 360 is located on a side that is of the piezoelectric layer 350 and that is away from the first electrode layer 330, and the piezoelectric layer 350 is located between the first electrode layer 330 and the second electrode layer 360. The first electrode layer and the second electrode layer are located on two sides of the piezoelectric layer, and can generate a specific potential difference, to drive the piezoelectric layer to perform bending vibration.

The piezoelectric unit in this application may be a piezoelectric device having a specific function, for example, a micro-electro-mechanical system (Micro-Electro-Mechanical System, MEMS) piezoelectric sensor or a speaker.

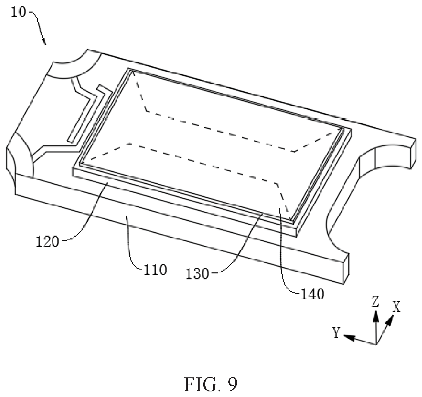

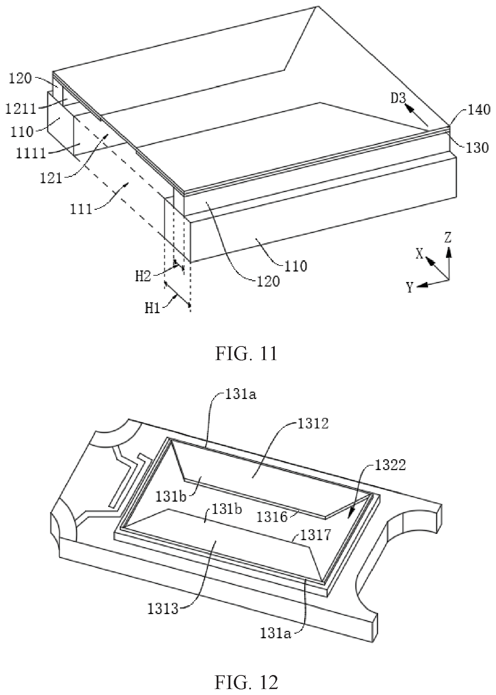

A piezoelectric speaker is used as an example in this application. This application provides a speaker unit 10. Refer to FIG. 9 to FIG. 12. The speaker unit 10 is formed by stacking a plurality of layers in a thickness direction (a Z direction in FIG. 11) of the speaker unit 10, and includes a circuit substrate 110, a base layer 120, a diaphragm layer 130, and an organic film 140. The base layer 120, the diaphragm layer 130, and the organic film 140 may be sequentially grown and formed on the circuit substrate 110, so that the circuit substrate 110, the base layer 120, the diaphragm layer 130, and the organic film 140 are sequentially stacked in the thickness direction. The base layer 120 may be the substrate 310 in the foregoing implementations, and the diaphragm layer 130 may be the piezoelectric layer 350 that is prepared on the electrode layer by using a chemical solution deposition (Chemical solution deposition, CSD) method in the foregoing implementations and whose lattice orientation is preferably (100). A lattice orientation ratio (100)/((100)+(001)) of the piezoelectric layer 350 ranges from 0.7 to 0.8.

Refer to FIG. 11. The base layer 120 is fastened on the circuit substrate 110, and the base layer 120 is provided with a first through hole 121 that interpenetrates each other in the thickness direction. The first through hole 121 is located at a central position of the base layer 120, so that the base layer 120 forms a "Hui" character-like structure. A peripheral frame structure of the first through hole 121 is fastened on the circuit substrate 110. The circuit substrate 110 is provided with a fourth through hole 111 that interpenetrates each other in the thickness direction. The fourth through hole 111 is located at a central position of the circuit substrate 110, so that the circuit substrate 110 forms a "Hui" character-like structure.

The fourth through hole 111 and the first through hole 121 interpenetrate each other in the thickness direction. A first peripheral wall surface 1211 (an inner wall surface of a central cavity of the base layer 120) of the first through hole 121 and a second peripheral wall surface 1111 (an inner wall surface of a central cavity of the circuit substrate 110) of the fourth through hole 111 may be flush. The first peripheral wall surface 1211 and the second peripheral wall surface 1111 are coplanar in the Z direction. Alternatively, the first peripheral wall surface 1211 and the second peripheral wall surface 1111 may not be coplanar in the Z direction, so that the base layer 120 and the circuit substrate 110 form a stepped structure at a joint. A width H1 of one side edge of the circuit substrate 110 in an X direction is greater than or equal to a width H2 of one side edge of the base layer 120 in the X direction, so that the circuit substrate 110 can better support the base layer 120 and support the diaphragm layer 130 and the organic film 140 that are disposed on the base layer 120.

In an embodiment, a width, in the X direction, of a side edge of the circuit substrate 110 on one side in the X direction is greater than or equal to a width, in the X direction, of a side edge of the base layer 120 on one side in the X direction, and a width, in the X direction, of a side edge of the circuit substrate 110 on one side in a direction opposite to the X direction is greater than or equal to a width, in the X direction, of a side edge of the base layer 120 on one side in the direction opposite to the X direction. Alternatively, a width, in the X direction, of one of two side edges, that is, a side edge of the circuit substrate 110 on one side in the X direction and a side edge of the circuit substrate 110 on one side in a direction opposite to the X direction is greater than or equal to a width of a side edge of the base layer 120 on the same side in the X direction, so that the circuit substrate 110 provides better support for the base layer 120.

In an embodiment, a width, in a Y direction, of a side edge of the circuit substrate 110 on one side in the Y direction is greater than or equal to a width, in the Y direction, of a side edge of the base layer 120 on one side in the Y direction, and a width, in the Y direction, of a side edge of the circuit substrate 110 in a direction opposite to the Y direction is greater than or equal to a width, in the Y direction, of a side edge of the base layer 120 in the direction opposite to the Y direction. Alternatively, a width, in a Y direction, of one of two side edges, that is, a side edge of the circuit substrate 110 on one side in the Y direction and a side edge of the circuit substrate 110 on one side in a direction opposite to the Y direction is greater than or equal to a width of a side edge of the base layer 120 on the same side in the Y direction, so that the circuit substrate 110 provides better support for the base layer 120.

It should be noted that dashed lines in FIG. 11 are merely used as examples to show positions of the first through hole 121 and the fourth through hole 111, so as to better display structures of the circuit substrate 110 and the base layer 120. A structure of the speaker unit 10 is not specifically or specially limited.

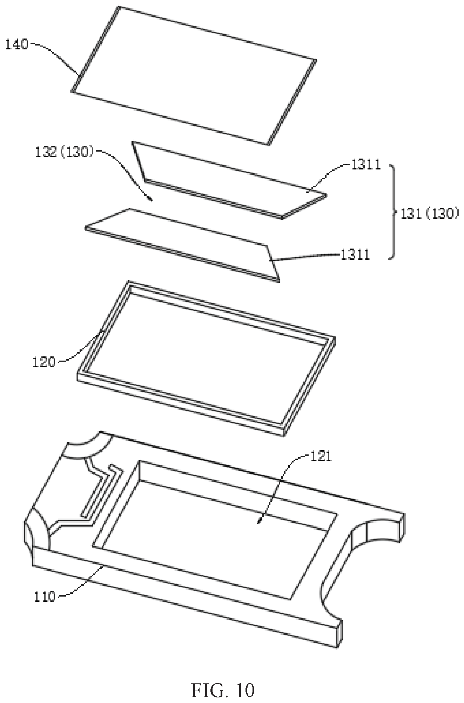

Refer to FIG. 10 and FIG. 12. The diaphragm 130 is disposed on the base layer 120, and the diaphragm 130 is disposed on the base layer 120 of a "Hui" character-shaped structure and is located on one side of the base layer 120 in the thickness direction. The diaphragm layer 130 includes a diaphragm 131. At least part of an edge of the diaphragm 131 is fastened to the base layer 120 to form a cantilever structure 1311. The diaphragm 131 includes a fastened portion 131a and a suspended portion 131b. At least a part of an edge of the fastened portion 131a of the diaphragm 131 is fastened to the base layer 120, and the suspended portion 131b of the diaphragm 131 is suspended on an inner side of the base layer 120 and extends from a frame of the "Hui" character-shaped of the base layer 120 towards a side of a second through hole 132, thereby forming the cantilever structure 1311. The diaphragm layer 130 includes at least one diaphragm 131. For example, the diaphragm layer 130 may include two diaphragms 131, that is, a first diaphragm 1312 and a second diaphragm 1312 (FIG. 12). The diaphragm 131 covers a part of the first through hole 121, that is, projection of at least a part of the diaphragm 131 in the thickness direction coincides with projection of the first through hole 121.

The second through hole 132 is provided between the diaphragm 131 and the base layer 120 and between adjacent diaphragms 131. The second through hole 132 and the first through hole 121 interpenetrate each other, and the second through hole 132 is located on a side of the first through hole 121 in a positive Y-direction. Refer to FIG. 12. The diaphragm 131 includes the first diaphragm 1312 and the second diaphragm 1313 that are oppositely disposed on the base layer 120. Both the first diaphragm 1312 and the second diaphragm 1313 may be in a shape of an isosceles trapezoid. Longer bottom edges of the isosceles trapezoids of both the first diaphragm 1312 and the second diaphragm 1313 are fastened to a frame structure of the base layer 120. Shorter bottom edges of the isosceles trapezoids of both the first diaphragm 1312 and the second diaphragm 1313 are parallel to each other and opposed to each other. The first diaphragm 1312 has a first edge 1316 on a side close to the second diaphragm 1313, and the second diaphragm 1313 has a second edge 1317 on a side close to the first diaphragm 1312. The second through hole 132 is spaced between the first edge 1316 and the second edge 1317.

In an embodiment, there is the second through hole 132 between the diaphragm 131 and the base layer 120. It may be understood that when the diaphragm layer 130 includes one diaphragm 131, the second through hole 132 is formed by enclosing a part of an edge of the diaphragm 131 and the base layer 120.

The diaphragm layer 130 is deformed under driving of a driving voltage, and the cantilever structure 1311 of the diaphragm layer 130 drives the diaphragm 131 to vibrate, to make a sound. A diaphragm actuating structure is disposed, so that the speaker unit 10 has the cantilever structure. Because one end of the cantilever structure 1311 is disposed in a suspended manner, actuating performance of the speaker unit 10 is improved, and output power of the speaker unit 10 can be improved.

It should be noted that a shape of the diaphragm 131 in FIG. 9 to FIG. 12 in this application is merely an example, and the shape of the diaphragm in this application is not specifically limited.

Refer to FIG. 9. The organic film 140 is disposed on the diaphragm layer 130, and covers the diaphragm layer 130. The organic film 140 is disposed in the thickness direction on a side of the diaphragm layer 130 in the Z direction and is fastened to the diaphragm layer 130. The organic film 140 completely seals the first through hole 121, that is, projection of the organic film 140 in the thickness direction completely covers the first through hole 121. The organic film 140 that completely seals the first through hole 121 is disposed, so that sound pressure can be prevented from being reduced without affecting an actuating action of the diaphragm 131.

In the speaker unit 10 provided in this embodiment, the diaphragm actuating structure is disposed, so that the speaker unit 10 has the cantilever structure, and the output power of the speaker unit 10 can be improved. In addition, the organic film 140 that seals the first through hole 121 is disposed, so that the sound pressure is avoided being reduced without affecting the actuating action of the diaphragm 131. Thus, with the foregoing structural design, it is advantageous to minimize a size of the speaker unit 10 and maximize the sound pressure in limited space. Therefore, the speaker unit 10 in this application can balance both miniaturization and an increase in the output power, and can meet a performance requirement of active noise reduction.

In addition, this application further provides an electronic device, including the piezoelectric unit in any one of the foregoing implementations. The piezoelectric unit may be a speaker unit or the like, and is driven by using a piezoelectric vibration feature, to implement functions such as generating a sound and driving a medium to flow.

Specifically, in this embodiment, an example in which the piezoelectric unit is a speaker unit. The speaker unit may be applied to electronic devices such as an earphone and a hearing aid.

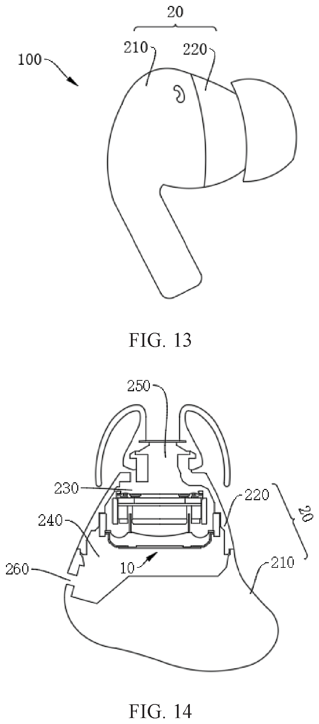

Refer to FIG. 13 and FIG. 14. FIG. 13 is a diagram of a structure of a true wireless earphone 100 according to an implementation provided in this application, and FIG. 14 is a sectional view of the true wireless earphone 100 shown in FIG. 13. The true wireless earphone 100 includes a speaker unit 10, a housing 20, and a controller (not shown in the figure). The housing 20 may include a first housing 210 and a second housing 220. The first housing 210 and the second housing 220 that are disposed opposite to each other enclose an inner cavity of the earphone, and the speaker unit 10 is integrated into the inner cavity of the earphone. The speaker unit 10 is disposed in the inner cavity of the earphone, and the inner cavity of the earphone is divided into a front cavity 230 and a rear cavity 240. The speaker unit 10 is provided with a front sound outlet 250 and a rear sound outlet 260. The front sound outlet 250 is connected to the front cavity 230, and the rear sound outlet 260 is connected to the rear cavity 240, to form a front sound outlet channel and a rear sound outlet channel of the true wireless earphone 100. The speaker unit 10 is electrically connected to the controller. After the speaker unit 10 receives an electrical signal, the controller drives the speaker unit 10 to vibrate, and converts the electrical signal into a sound signal, to play a sound and transmit the sound to an ear of a user.

With development of information communication technologies and electronic devices, electronic devices such as earphones are developed towards miniaturization and portability. A speaker unit 10 built in the electronic device not only needs to evolve in a direction of miniaturization, but also needs to ensure that acoustic performance of the speaker unit 10 reaches, for example, a sound pressure level or a wider frequency bandwidth, to meet a user requirement.

The foregoing embodiments are merely intended for describing technical solutions of this application, but not for limiting this application. Although this application is described in detail with reference to the foregoing embodiments, a person of ordinary skill in the art should understand that modifications may still be made to the technical solutions described in the foregoing embodiments or equivalent replacements may be made to some technical features thereof, without departing from the spirit and scope of the technical solutions in embodiments of this application, and these modifications and replacements shall fall within the scope of protection of this application.

## Claims

1. A piezoelectric unit, comprising a substrate, a monocrystalline dielectric oxide layer, a first electrode layer, a perovskite-type monocrystalline seed crystal layer, and a piezoelectric layer that are stacked, wherein a lattice orientation ratio (100)/((100)+(001)) of the piezoelectric layer ranges from 0.7 to 0.8.

2. The piezoelectric unit according to claim 1, wherein the substrate comprises a monocrystalline silicon substrate or a monocrystalline SOI substrate whose lattice orientation is (100).

3. The piezoelectric unit according to claim 1 or 2, wherein a lattice orientation ratio (100)/((100)+(001)) of at least one of the monocrystalline dielectric oxide layer, the first electrode layer, and the perovskite-type monocrystalline seed crystal layer ranges from 0.7 to 0.8.

4. The piezoelectric unit according to any one of claims 1 to 3, wherein the piezoelectric unit further comprises a second electrode layer, the second electrode layer is located on a side that is of the piezoelectric layer and that is away from the first electrode layer, and the piezoelectric layer is located between the first electrode layer and the second electrode layer.

5. The piezoelectric unit according to claim 4, wherein the substrate has a frame structure, and is provided with a first through hole that interpenetrates each other in a thickness direction;
the piezoelectric layer is located on a side of the substrate in the thickness direction and comprises at least one diaphragm, there is a second through hole between the diaphragm and the substrate and/or between two adjacent diaphragms, at least a part of an edge of the diaphragm is fastened to the substrate to form a cantilever structure, the diaphragm covers a part of the first through hole, and the second through hole and the first through hole interpenetrate each other; and
the piezoelectric unit further comprises an organic film, and the organic film covers the diaphragm and the second through hole.

6. An electronic device, comprising a housing and the piezoelectric unit according to any one of claims 1 to 5, wherein the housing encloses an inner cavity, and the piezoelectric unit is located in the inner cavity and is fastened in the housing.

7. The electronic device according to claim 6, wherein the electronic device further comprises a controller, the controller is electrically connected to the piezoelectric unit, and the controller is configured to control vibration of the piezoelectric unit.

8. A piezoelectric unit preparation method, used to prepare the piezoelectric unit according to any one of claims 1 to 7, and comprising the following steps:
sequentially forming a monocrystalline dielectric oxide layer, a first electrode layer, and a perovskite-type monocrystalline seed crystal layer on a monocrystalline substrate, wherein the monocrystalline dielectric oxide layer is a monocrystalline oxide layer epitaxially grown on the monocrystalline substrate;
coating a precursor solution on the perovskite-type monocrystalline seed crystal layer to form an intermediate, wherein the intermediate comprises the monocrystalline substrate, the monocrystalline dielectric oxide layer, the first electrode layer, the perovskite-type monocrystalline seed crystal layer, and the precursor solution; and
drying, calcining, and cooling the intermediate, so that the precursor solution crystallizes and solidifies into a piezoelectric layer.

9. The piezoelectric unit preparation method according to claim 8, wherein a lattice orientation of the monocrystalline substrate is (100).

10. The piezoelectric unit preparation method according to claim 8 or 9, wherein a step of coating the precursor solution on the perovskite-type monocrystalline seed crystal layer comprises:
the precursor solution contains zirconium and titanium, and a ratio of zirconium to titanium in the precursor solution is adjusted to determine that an orientation ratio (100)/((100)+(001)) of the piezoelectric layer formed through drying, calcination, and cooling ranges from 0.7 to 0.8.

11. The piezoelectric unit preparation method according to claim 10, wherein a ratio of a molar quantity of zirconium to a molar quantity of titanium in the precursor solution ranges from 0.5 to 1.

12. The piezoelectric unit preparation method according to any one of claims 8 to 11, wherein a step of calcining the precursor solution comprises:
heating the precursor solution to a first preset temperature, until the precursor solution is sintered and solidified; and
continuing to heat the precursor solution to a second preset temperature, so that the precursor solution crystallizes.
